# EUROPEAN PATENT SPECIFICATION

(11) **EP 4 297 071 B1**
(45) Date of publication and mention of the grant of the patent: **04.11.2026**
(21) Application number: 22755886.3
(22) Date of filing: 28.01.2022
(51) Int. Cl.: H10W 72/90, H10W 72/20, H10W 72/00, H01S 5/0234, H01S 5/0237

(54) **ELECTRONIC DEVICE**
ELEKTRONISCHE VORRICHTUNG
DISPOSITIF ÉLECTRONIQUE

(30) Priority: 19.02.2021 JP 2021025311
(43) Date of publication of application: 27.12.2023
(73) Proprietor: Sony Semiconductor Solutions Corporation, Atsugi-shi, Kanagawa 243-0014 (JP)
(72) Inventor: IMAHIGASHI, Takashi, Kikuchi-gun, Kumamoto 869-1102 (JP)
(74) Representative: Müller Hoffmann & Partner
(86) International application number: PCT/JP2022/003199
(87) International publication number: WO 2022/176563

(56) References cited:
- WO-A1-2011/114751
- WO-A1-2020/162142
- WO-A1-2020/162390
- JP-A- 2000 077 458
- JP-A- 2003 174 055
- JP-A- 2010 278 139
- JP-A- 2011 216 475
- JP-A- 2013 098 514
- JP-A- 2014 090 098
- JP-A- 2018 160 589
- JP-A- H0 637 143
- JP-A- H11 168 116
- US-A- 5 448 114
- US-A1- 2010 294 552
- US-A1- 2016 300 808

## Description

### Field

The present disclosure relates to an electronic device.

### Background

An electronic device in which an electronic circuit element is flip-chip connected onto a substrate is sealed with, for example, resin in order to prevent entry of cutting water used when each electronic device is divided from a semiconductor wafer.

However, when an electronic device is sealed with resin, there are problems such as contamination of an electrode by the resin, prolongation of working time due to injection of the resin for each electronic device, and an increase in the amount of resin to be discarded due to the prolongation of working time.

Therefore, there is an electronic device in which an electrode of an electronic circuit element and an electrode of a substrate are connected by gold-tin bonding, gold-silver bonding, gold-aluminum bonding, or gold-gold bonding, and a peripheral edge portion of the electronic circuit element and an opposing substrate are bonded and sealed by the same connection method as the inter-electrode connection (see, for example, Patent Literature 1). An electronic device in which a chip electrode of the electronic circuit element and an internal electrode of the substrate are connected by gold-tin (Au-Sn) bonding, gold-silver (Au-Ag) bonding, gold-aluminum (Au-Al) bonding, or gold-gold (Au-Au) bonding, and a peripheral edge portion of the electronic circuit element or a portion requiring sealing and the opposing substrate are bonded and sealed by the same connection method as described above.

### Citation List

### Patent Literature

Patent Literature 1: JP 2004-214469 A
WO 2020/162390 A1 teaches an electronic device with a semiconductor substrate, a chip, and a connection part. The connection part includes a porous metal layer for connection pads that are arranged on opposing principle surfaces of the semiconductor substrate and the chip. The connection part is defined to include bumps. In an embodiment, all bumps are electrically connected, wherein to that end, the outer bumps are provided with electrically conducting sidewalls. Similar bumps are shown to be used in an electric component mounted structure as described in US 2010/ 294552 A1. US 5 448 114 A discloses a semiconductor device with chip electrodes and a perimeter electrode surrounding the chip electrodes. Summary

### Technical Problem

However, in the conventional technique described above, when the electronic circuit element or the substrate has a variation in thickness or warpage, a gap is generated with respect to the metal of the sealed portion, and the airtightness of the electronic device may be reduced. Thus, the present disclosure proposes an electronic device capable of improving airtightness.

### Solution to Problem

The above problem is solved by the subject-matter of the independent claim.

According to the present disclosure, an electronic device is provided. The electronic device according to the present disclosure includes a semiconductor substrate, a chip, a bump, and a sidewall portion. The bump connects a plurality of connection pads provided on the opposing main surfaces of the semiconductor substrate and the chip. The sidewall portion includes a porous metal layer that annularly surrounds a region where a plurality of bumps is provided, and connects the semiconductor substrate and the chip.

### Brief Description of Drawings

FIG. 1 is an explanatory cross-sectional view of an electronic device according to an embodiment of the present disclosure.
FIG. 2 is an explanatory cross-sectional view taken along line A-A illustrated in FIG. 1.
FIG. 3 is an explanatory view illustrating a process of forming bumps and a sidewall portion on a semiconductor substrate according to the present disclosure.
FIG. 4 is an explanatory view illustrating a process of forming bumps and a sidewall portion on a semiconductor substrate according to the present disclosure.
FIG. 5 is an explanatory view illustrating a process of forming bumps and a sidewall portion on a semiconductor substrate according to the present disclosure.
FIG. 6 is an explanatory view illustrating a process of forming bumps and a sidewall portion on a semiconductor substrate according to the present disclosure.
FIG. 7 is an explanatory view illustrating a process of forming bumps and a sidewall portion on a chip according to the present disclosure.
FIG. 8 is an explanatory view illustrating a process of forming bumps and a sidewall portion on a chip according to the present disclosure.
FIG. 9 is an explanatory view illustrating a process of forming bumps and a sidewall portion on a chip according to the present disclosure.
FIG. 10 is an explanatory view illustrating a process of forming bumps and a sidewall portion on a chip according to the present disclosure.

### Description of Embodiments

The embodiment of the present disclosure will be described below in detail on the basis of the drawings. Note that, in each embodiment described below, the same parts are designated by the same reference numerals and the same hatching, and duplicate description will be omitted.

### [1. Cross-Sectional Structure of Electronic Device]

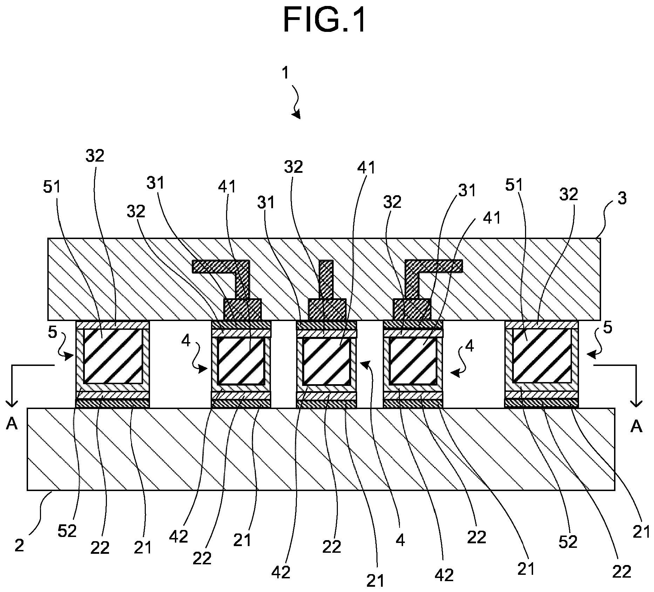

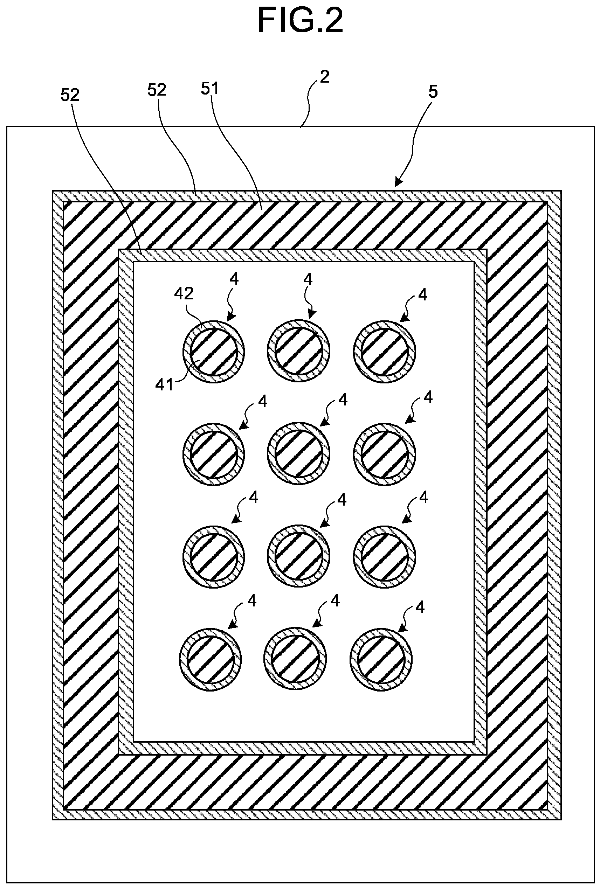

FIG. 1 is an explanatory cross-sectional view of an electronic device according to an embodiment of the present disclosure. FIG. 2 is an explanatory cross-sectional view taken along line A-A illustrated in FIG. 1. As illustrated in FIG. 1, an electronic device 1 according to the present disclosure includes a semiconductor substrate 2, a chip 3, and bumps 4 that connect connection pads 21 and 31 provided on opposing main surfaces of the semiconductor substrate 2 and the chip **3.**

Further, as illustrated in FIGS. 1 and 2, the electronic device 1 includes a sidewall portion 5 which includes a porous metal layer 51 that annularly surrounds a region where the plurality of bumps 4 is provided, and which connects the semiconductor substrate 2 and the chip **3. In** addition, in the electronic device 1, the connection pad 21 is also provided between the sidewall portion 5 and the semiconductor substrate **2.** The connection pad 21 provided between the sidewall portion 5 and the semiconductor substrate 2 is not connected to a circuit inside the semiconductor substrate **2.**

The chip 3 is, for example, a semiconductor laser, and includes a plurality of connection pads 31 on one main surface of a gallium arsenide (GaAs) base material. In addition, the chip 3 includes a light emitting portion of the semiconductor laser or the like inside the base material. The light emitting portion includes a plurality of two-dimensionally arranged light emitting elements that emits laser light. The light emitting elements are connected to the connection pads 31 in the chip **3.**

Note that the electronic component included in the chip 3 may be any electronic component other than the light emitting portion of the semiconductor laser. In addition, the base material of the chip 3 may be, for example, a semiinsulating base material such as of indium phosphide (InP).

The semiconductor substrate 2 is, for example, a silicon (Si) substrate, and includes therein a drive circuit for driving the semiconductor laser. The semiconductor substrate 2 includes the plurality of connection pads 21 on one main surface. The connection pads 21 are connected to the drive circuit inside the semiconductor substrate **2.** Note that the electronic circuit included in the semiconductor substrate 2 may be any electronic circuit other than the drive circuit for the semiconductor laser.

In the electronic device 1, the chip 3 is flip-chip mounted on the semiconductor substrate 2, and the drive circuit in the semiconductor substrate 2 and the chip 3, which is a semiconductor laser, are electrically connected by the bumps 4. In addition, in the electronic device 1, a space in which the connection pads 21 and 31 and the bumps 4 are provided is hermetically sealed by the sidewall portion 5.

Here, for example, in a case where the electronic device is manufactured by flip-chip mounting the chip 3 including the semiconductor laser on the semiconductor substrate 2 including the drive circuit for the semiconductor laser, a plurality of drive circuits is first formed on a Si wafer in a general manufacturing method.

Thereafter, the chip 3 is stacked via bulk-shaped metal bumps on each drive circuit, and the connection pads 21 and 31 provided on the opposing main surfaces of the drive circuit and the chip 3 are connected to each other by the bumps. Then, the Si wafer is diced into individual pieces for each electronic device.

In the process of dividing the Si wafer into individual pieces for each electronic device, dicing is performed while supplying cutting water to the Si wafer. At this time, when the cutting water enters between the semiconductor substrate 2 and the chip 3, it adversely affects the electronic device. Therefore, generally, each electronic device is sealed with resin, and then the Si wafer is divided into individual pieces for each electronic device.

However, when an electronic device is sealed with resin, there are problems such as contamination of an electrode by the resin, prolongation of working time due to injection of the resin for each electronic device, and an increase in the amount of resin to be discarded after the expiration date due to the prolongation of working time.

Therefore, there is a technique in which the connection pads 21 and 31 provided on the opposing main surfaces of the semiconductor substrate 2 and the chip 3 are connected by the bumps, and the region where the connection pads 21 and 31 and the bumps are provided and that needs to be sealed is bonded and sealed by the same connection method as the connection between the connection pads 21 and 31.

In addition, in general flip-chip mounting, the chip 3 is mounted on the semiconductor substrate 2 by pressing and heating bulk-shaped bumps made of metal such as gold (Au), copper (Cu), or solder provided on the opposing main surfaces of the semiconductor substrate 2 and the chip 3.

However, in a case where the thermal expansion coefficients of the semiconductor substrate 2 and the chip 3 are different from each other by, for example, 0.1 ppm/°C or more, when bulk-shaped Au, Cu, solder, or the like is used as the material of the bumps, the problems described below occur.

For example, when bulk-shaped Au is used as the material of the bumps, it is necessary to heat the bumps to a high temperature of 300°C or higher and apply a high pressure of 100 MPa or more between the semiconductor substrate 2 and the chip 3 in order to stably connect the semiconductor substrate 2 and the chip 3 having different thermal expansion coefficients using the bumps.

In addition, when bulk-shaped Cu is used as the material of the bumps, heating at 380°C or higher is necessary. As described above, when bulk-shaped Au or Cu is used as the material of the bumps, it is necessary to perform connection using the bumps at a high temperature and a high pressure, and the high temperature and the high pressure may damage the chip 3, and the reliability of the electronic device may be lowered.

On the other hand, when solder is used as the material of the bumps, connection by the bumps can be performed at a lower temperature and a lower pressure as compared with Au and Cu, but the solder is inferior in heat resistance and connection strength to Au and Cu. Therefore, when the chip 3 is thermally expanded due to heat generation of the electronic component such as a semiconductor laser mounted on the chip 3, for example, there is a possibility that open failure occurs due to a difference in thermal expansion coefficient between the semiconductor substrate 2 and the chip 3, and the bumps made of solder lowers the reliability of the electronic device.

In addition, as described above, the semiconductor substrate 2 according to the present disclosure is a Si substrate, and has a thermal expansion coefficient of 5.7 ppm/°C. On the other hand, the base material of the chip 3 according to the present disclosure is GaAs and has a thermal expansion coefficient of 2.6 ppm/°C.

As described above, in the electronic device 1, the difference in thermal expansion coefficient between the semiconductor substrate 2 and the chip 3 is much larger than 0.1 ppm/°C. Therefore, in the electronic device 1, when the material of the bumps is bulk-shaped Au, Cu, or solder, there is a possibility that the problems described above occur and the reliability is lowered.

In addition, in a case where the peripheral edge portion of the region between the semiconductor substrate 2 and the chip 3 that needs to be sealed is surrounded, bonded, and sealed by a bulk-shaped metal having a plated surface, when the thermal expansion coefficient between the semiconductor substrate 2 and the chip 3 is different by, for example, 0.1 ppm/°C or more, a crack occurs in the sealed portion. Hence, airtightness of the electronic device is reduced.

Further, when the semiconductor substrate 2 or the chip 3 has a variation in thickness or warpage, when the semiconductor substrate 2 and the chip 3 are stacked, the semiconductor substrate 2 and the chip 3 can be bonded only at protrusions of the convex surface of the plating film at the sealed portion.

As a result, in the electronic device, gaps are scattered at the sealed portion, so that airtightness is reduced. In addition, when the semiconductor substrate 2 and the chip 3 are bonded by temperature increase and pressure increase in order to prevent generation of gaps at the sealed portion, there is a possibility that short-circuit failure occurs between adjacent fine bumps in the electronic device.

Thus, the bump 4 of the electronic device 1 includes, for example, a porous metal layer 41 of Au. The porous metal layer 41 contains Au particles having a particle diameter of 0.005 µm to 1.0 µm and a purity of 99.9 wt% or more. Note that the component of the porous metal layer 41 may be, for example, Cu, silver (Ag), or platinum (Pt) having a purity of 99.9 wt% or more.

The porous metal layer 41 containing metal particles having a particle diameter of 0.005 µm to 1.0 µm can be metal-bonded at a temperature lower than the melting point of the bulk-shaped metal due to the size effect of the particle diameter. For example, the porous metal layer 41 can connect the semiconductor substrate 2 and the chip 3 at a temperature of about 100°C when the component is Au, about 250°C in the case of Ag, and about 150°C in the case of Cu. Hence, the electronic device 1 can reduce damage to the chip 3 due to heat, and thus can improve reliability.

In addition, since the porous metal layer 41 has elasticity, for example, even when the chip 3 expands with a thermal expansion coefficient different from that of the semiconductor substrate 2 due to heat generation of the semiconductor laser, the porous metal layer 41 is elastically deformed, and thus it is possible to suppress the occurrence of open failure. Hence, the electronic device 1 can improve reliability as compared with, for example, a case where the bumps made of solder are used.

The electronic device 1 is manufactured by stacking the chip 3 on the semiconductor substrate 2 provided with the bumps 4 on the upper surface, connecting, without melting, the porous metal layers 41 of the bumps 4 to the connection pads 31, and flip-chip mounting the chip 3 on the semiconductor substrate 2.

In addition, the electronic device 1 may be manufactured by stacking the chip 3 provided with the bumps 4 including the porous metal layers 41 on the lower surface on the semiconductor substrate 2, connecting, without melting, the porous metal layers 41 of the bumps 4 to the connection pads 21, and flip-chip mounting the chip 3 on the semiconductor substrate 2. Note that the bumps 4 including the porous metal layers 41 may be provided on both the semiconductor substrate 2 and the chip 3 before stacking.

When provided on the semiconductor substrate 2 side, the bump 4 includes a metal film 42 between the porous metal layer 41 and the connection pad 21 on the semiconductor substrate 2 side. In addition, when provided on the chip 3 side, the bump 4 includes a metal film 42 between the porous metal layer 41 and the connection pad 31 on the chip 3 side. Note that the metal film 42 may be provided at least one of between the porous metal layer 41 and the connection pad 21 on the semiconductor substrate 2 side and between the porous metal layer 41 and the connection pad 31 on the chip 3 side.

In the present disclosure, by setting the proportion of the film thickness of the metal film 42 to the thickness of the bump 4 in a direction orthogonal to the main surface of the semiconductor substrate 2 to less than 10%, it is possible to achieve a fine pitch in which the pitch of the bumps 4 is 20 µm or less. Such a fine pitch will be described below together with the formation process of the bumps 4.

Further, the bump 4 also includes a metal film 42 on side surface (side peripheral surfaces) of the porous metal layer 41. The material of the metal film 42 is desirably the same as that of the porous metal layer 41. For example, when the material of the porous metal layer 41 is Au, the metal film 42 is desirably an Au film.

Hence, since the side surface of the porous metal layer 41 is coated with the metal film 42, the bump 4 can prevent the particles of the porous metal layer 41 from collapsing and scattering. Accordingly, the bumps 4 can prevent the adjacent bumps 4 from being short-circuited by the scattering of the particles of the porous metal layers 41.

In addition, when the metal film 42 is not provided on the side surface of the porous metal layer 41, surface roughness occurs on the side surface of the porous metal layer 41 the surface of which is relatively soft, and the shape varies among the bumps 4.

On the other hand, since the metal film 42 harder than the porous metal layer 41 is provided on the side surface of the porous metal layer 41 of the bump 4, variations in the shape among the bumps 4 are suppressed, and all have a uniform shape. Moreover, since the side surface of the bump 4 is coated with the relatively hard metal film 42, further miniaturization becomes possible, enabling a finer pitch.

In addition, the bump 4 is slightly crushed in the thickness direction when the chip 3 is flip-chip mounted on the semiconductor substrate 2, but prevents the particles of the porous metal layer 41 from leaking to the outside of the metal film 42. As a result, in the bump 4, the particle density of the porous metal layer 41 inside the metal film 42 increases, so that the connection resistance can be reduced.

In addition, the sidewall portion 5 of the electronic device 1 has the same structure as the bump 4. Specifically, the sidewall portion 5 includes the porous metal layer 51 of Au. The porous metal layer 51 contains Au particles having a particle diameter of 0.005 µm to 1.0 µm and a purity of 99.9 wt% or more. Note that the component of the porous metal layer 51 may be, for example, Cu, silver (Ag), or platinum (Pt) having a purity of 99.9 wt% or more.

The porous metal layer 51 can be metal-bonded at a temperature lower than the melting point of the bulk-shaped metal due to the size effect of the particle diameter as described above. Hence, the electronic device 1 can reduce damage to the chip 3 due to heat at the time of formation of the porous metal layer 51, and thus can improve reliability.

In addition, since the porous metal layer 51 has elasticity, for example, even when the chip 3 expands with a thermal expansion coefficient different from that of the semiconductor substrate 2 due to heat generation of the semiconductor laser, the porous metal layer 51 is elastically deformed, and thus it is possible to suppress the occurrence of a crack in the sidewall portion 5. Hence, the electronic device 1 can improve airtightness of the region where the connection pads 21 and 31 and the bumps 4 are provided and that needs to be sealed.

In addition, since the porous metal layer 51 is elastically deformed, for example, even when the semiconductor substrate 2 or the chip 3 has a variation in thickness or warpage, the porous metal layer 51 is deformed following the surface shape of the semiconductor substrate 2 or the chip 3 when the semiconductor substrate 2 and the chip 3 are bonded.

Hence, the electronic device 1 can suppress generation of gaps at the connection portion between the sidewall portion 5 and the semiconductor substrate 2 and the connection portion between the sidewall portion 5 and the chip 3, so that airtightness can be improved.

In addition, as illustrated in FIG. 2, the sidewall portion 5 is provided so as to annularly surround the region where the connection pads 21 and 31 and the bumps 4 are provided and that needs to be sealed. Hence, when the semiconductor substrate 2 or the chip 3 thermally expands, the electronic device 1 can alleviate mechanical stress applied to the bumps 4 provided at the corner portions.

Specifically, in a case where the semiconductor substrate 2 or the chip 3 thermally expands, the amount of expansion and the amount of contraction due to temperature changes increase from the center of the main surface of the semiconductor substrate 2 or the chip 3 toward the peripheral edge portion. Therefore, without the sidewall portion 5, mechanical stress is applied to the bumps 4 provided at the corner portions.

On the other hand, in the electronic device 1, since the peripheral edge portions of the semiconductor substrate 2 and the chip 3 are sealed by the sidewall portion 5, expansion and contraction of the peripheral edge portions of the semiconductor substrate 2 and the chip 3 due to temperature changes can be suppressed by the sidewall portion 5. Hence, the electronic device 1 can alleviate mechanical stress applied to the bumps 4 provided at the corner portions.

When provided on the semiconductor substrate 2 side, the sidewall portion 5 includes a metal film 52 between the porous metal layer 51 and the connection pad 21 on the main surface of the semiconductor substrate 2. In addition, when provided on the chip 3 side, the sidewall portion 5 includes a metal film 52 between the porous metal layer 51 and the connection pad on the main surface of the chip 3. Note that the metal film 52 may be provided at least one of between the porous metal layer 51 and the connection pad 21 on the main surface of the semiconductor substrate 2 and between the porous metal layer 51 and the connection pad on the main surface of the chip 3.

In the present disclosure, by setting the proportion of the film thickness of the metal film 52 to the thickness of the sidewall portion 5 in a direction orthogonal to the main surface of the semiconductor substrate 2 to less than 10%, it is possible to achieve a fine pitch in which the pitch of the bumps 4 is 20 µm or less in a process of simultaneously forming the sidewall portion 5 and the bumps 4.

Further, the sidewall portion 5 also includes a metal film 52 on side surfaces (side peripheral surfaces) of the porous metal layer 51. The material of the metal film 52 is desirably the same as that of the porous metal layer 51. For example, when the material of the porous metal layer 51 is Au, the metal film 52 is desirably an Au film.

Hence, since the side surfaces of the porous metal layer 51 are coated with the metal film 52, the sidewall portion 5 can prevent the particles of the porous metal layer 51 from collapsing and scattering. Accordingly, the sidewall portion 5 can prevent the adjacent bumps 4 from being short-circuited by the scattering of the particles of the porous metal layers 51.

In addition, when the metal film 52 is not provided on the side surfaces of the porous metal layer 51, surface roughness occurs on the side surfaces of the porous metal layer 51 the surface of which is relatively soft, and the shape of the side surfaces of the sidewall portion 5 varies.

On the other hand, since the metal film 52 harder than the porous metal layer 51 is provided on the side surfaces of the porous metal layer 51 of the sidewall portion 5, variations in the shape of the side surfaces are suppressed, and the entire side surfaces have a uniform surface shape. Moreover, since the side surfaces of the sidewall portion 5 are coated with the relatively hard metal film 52, further miniaturization becomes possible.

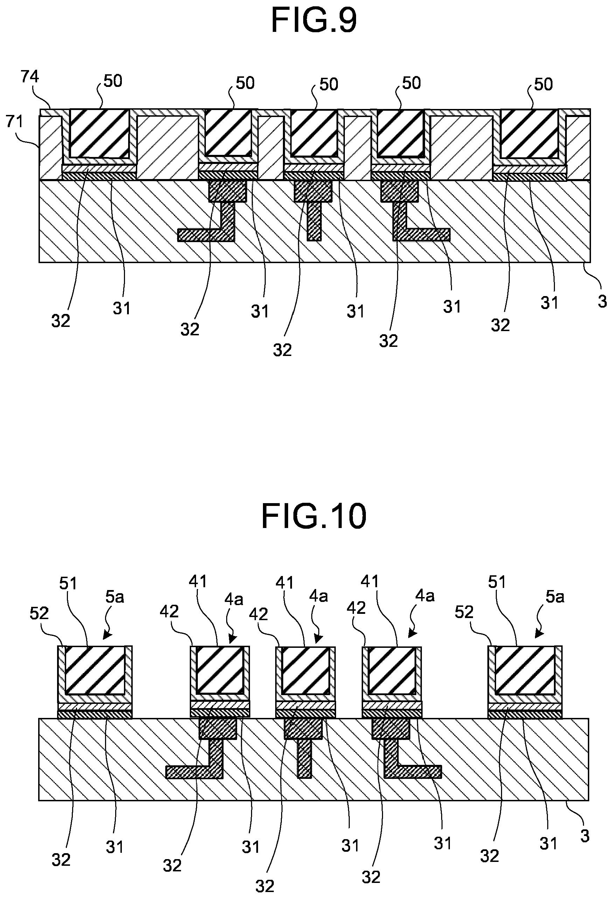

The electronic device 1 is manufactured by stacking the chip 3 not provided with bumps 4a (see FIG. 10) on the semiconductor substrate 2 provided with the bumps 4 on the upper surface, connecting, without melting, the porous metal layers 41 of the bumps 4 to the connection pads 31, and flip-chip mounting the chip 3 on the semiconductor substrate 2.

In addition, the electronic device 1 may be manufactured by stacking the chip 3 provided with the bumps 4a (see FIG. 10) including the porous metal layers 41 on the lower surface on the semiconductor substrate 2 not provided with the bumps 4, connecting, without melting, the porous metal layers 41 of the bumps 4a to the connection pads 21, and flip-chip mounting the chip 3 on the semiconductor substrate 2. Note that the bumps 4 and 4a including the porous metal layers 41 may be provided on both the semiconductor substrate 2 and the chip 3 before stacking.

### [2. Process of Forming Bumps and Sidewall Portion]

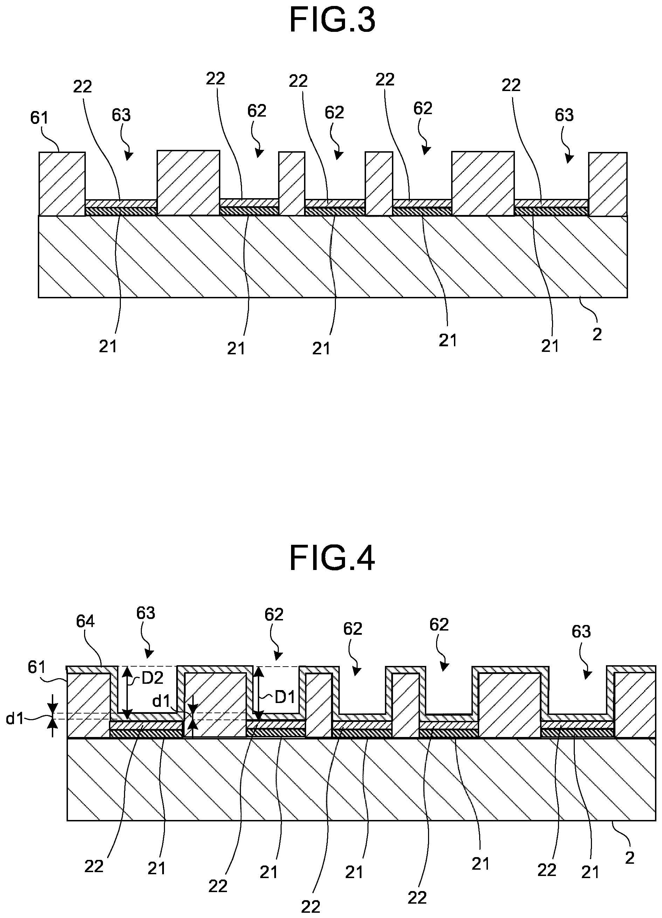

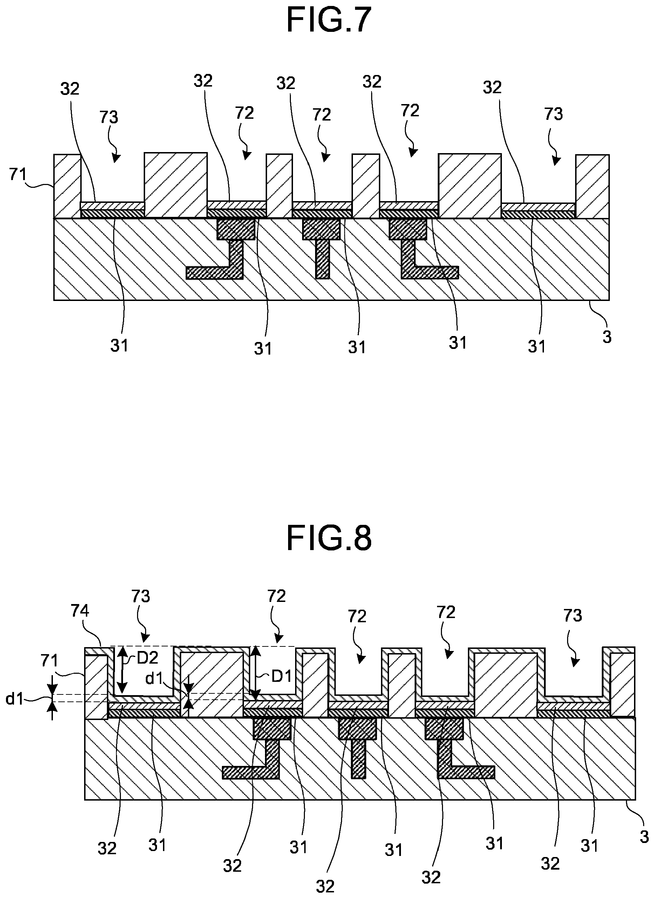

Next, a process of forming the bumps and the sidewall portion according to the present disclosure will be described with reference to FIGS. 3 to 10. FIGS. 3 to 6 are explanatory views illustrating a process of forming the bumps and the sidewall portion on the semiconductor substrate according to the present disclosure. FIGS. 7 to 10 are explanatory views illustrating a process of forming the bumps and the sidewall portion on the chip according to the present disclosure.

As illustrated in FIG. 3, in the case of forming the bumps 4 and the sidewall portion 5 on the semiconductor substrate 2, first, a metal film 22 is formed on the upper surfaces of the connection pads 21 provided at the position where the bumps 4 are to be formed later on the semiconductor substrate 2. At this time, at the same time, a metal film 32 is also formed on the upper surfaces of the connection pads 21 provided at the position where the sidewall portion 5 is to be formed later, that is, the upper surfaces of the connection pads 21 provided at the position annularly surrounding the region where the bumps 4 are to be formed later on the main surface of the semiconductor substrate 2. As a material of the metal film 22, a metal having the same component as that of a metal film 64 (see FIG. 4) to be stacked later is selected. Note that, here, the metal film 22 of Au is formed.

Thereafter, a photoresist layer 61 is formed on the surface of the semiconductor substrate 2 on the side where the connection pads 21 and the metal films 22 are provided. Thereafter, through-holes 62 are formed at the position where the bumps 4 are to be formed in the photoresist layer 61 by a photolithography technique to expose the surface of the metal films 22. At the same time, a groove 63 is formed at the position where the sidewall portion 5 is to be formed to expose the surface of the metal film 22.

At this time, the through-holes 62 are formed such that an interval between centers of adjacent through-holes 62 is 20 µm (20 µm pitch). The through-holes 62 are filled with a paste 50 containing metal particles to be a material of the porous metal layer 41 in a later process, but because of a fine structure having a 20 µm pitch, when the paste 50 is charged in this state, there is a possibility that the fine structure may be damaged and collapsed.

Thus, as illustrated in FIG. 4, the metal film 64 is formed on the upper surface of the photoresist layer 61, the side surfaces of the through-holes 62, the side surfaces of the groove 63, and the upper surfaces of the metal films 22 by, for example, sputtering. As a material of the metal film 64, a metal having the same component as the metal particles contained in the paste 50 to be charged into the through-holes 62 later is selected. Note that, here, the metal film 64 of Au is formed.

Hence, since the photoresist layer 61 is cured by coating the surface with the metal film 64, it is possible to prevent the fine structure from being collapsed when the through-holes 62 are filled with the paste 50 containing metal particles.

In addition, when the film thickness of the metal film 64 formed here is too thick, the openings of the through-holes 62 become narrow, and it becomes difficult to fill the through-holes 62 with the paste 50 containing metal particles. Thus, here, a thin (for example, a thickness of less than 1 µm) metal film 64 is formed such that the proportion of a film thickness d1 of the metal film 64 to a depth D1 of the through-hole 62, in other words, a thickness of the bump 4 to be formed later (a height D1 of the bump 4) in the direction orthogonal to the main surface of the semiconductor substrate 2 is less than 10%.

For example, in the case of forming the bumps 4 having a height of 10 µm arranged at a 20 µm pitch, the film thickness of the metal film 64 is set to 0.2 µm. Hence, even when the metal film 64 is formed, it is possible to prevent the openings of the through-holes 62 from being narrowed, so that the through-holes 62 can be sufficiently filled with the paste 50 containing metal particles in a later process.

As a result, the proportion of the film thickness d1 of the metal film 64 to a depth D2 of the groove 63, in other words, a thickness of the sidewall portion 5 to be formed later (a height D2 of the sidewall portion 5) in the direction orthogonal to the main surface of the semiconductor substrate 2 is less than 10%.

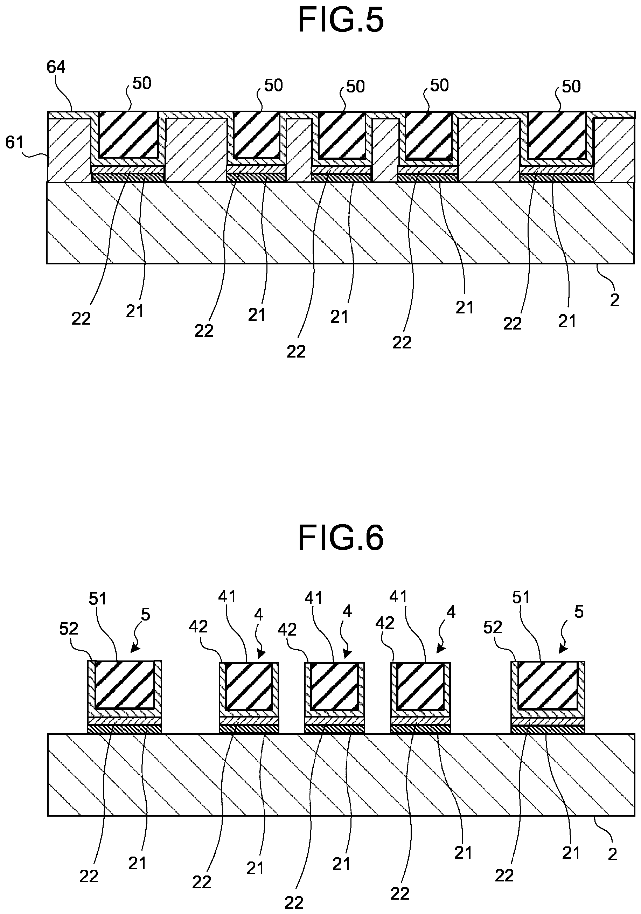

Subsequently, as illustrated in FIG. 5, the through-holes 62 and the groove 63 formed in the photoresist layer 61 are filled with the paste 50 containing Au particles having, for example, a purity of 99.9 wt% or more and a particle diameter of 0.005 µm to 1.0 µm. As a method of filling the through-holes 62 and the groove 63 with the paste 50, for example, any method such as screen printing or a method of spreading the dropped paste 50 with a spatula can be used.

Thereafter, the paste 50 is dried and sintered, and then the photoresist layer 61 is stripped by lift-off using a stripping solution or the like. Hence, as illustrated in FIG. 6, the metal film 22 of Au, the metal film 42 of Au, and the porous metal layer 41 containing Au particles having a particle diameter of 0.005 µm to 1.0 µm are sequentially stacked on the surface of the connection pads 21, and the bumps 4 in which the metal film 42 of Au is also formed on the side surfaces of the porous metal layers 41 are completed.

At the same time, the metal film 22 of Au, the metal film 52 of Au, and the porous metal layer 51 containing Au particles having a particle diameter of 0.005 µm to 1.0 µm are sequentially stacked to surround the region where the bumps 4 are formed, and the sidewall portion 5 in which the metal film 52 of Au is also formed on the side surfaces of the porous metal layer 51 is completed.

As described above, the bump 4 includes the metal film 42 in which the proportion of the film thickness to the height D1 of the bump 4 is less than 10% between the metal film 22 on the connection pad 21 and the porous metal layer 41. Further, the bump 4 is also provided with the metal film 42 on the side surface of the porous metal layer 41.

In addition, the sidewall portion 5 includes the metal film 52 in which the proportion of the film thickness to the height D2 of the sidewall portion 5 is less than 10% between the metal film 22 on the connection pad 21 and the porous metal layer 51. Further, the sidewall portion 5 is also provided with the metal film 52 on the side surfaces of the porous metal layer 51.

The metal films 42 and 52 are formed on the upper surface of the photoresist layer 61, the side surfaces of the through-holes 62 and the groove 63 formed in the photoresist layer 61, and the surface of the metal film 22 in order to prevent collapse of the fine structures of the bumps 4 and the sidewall portion 5 patterned in the photoresist layer 61. Hence, the bumps 4 can have a fine pitch having a pitch of 20 µm or less.

In addition, since the metal film 22 is formed on the surface of the connection pad 21 by sputtering, the metal film 22 is firmly bonded to the connection pad 21 even when the connection pad 21 is a metal having a component different from that of the metal film 22.

In addition, the metal films 42 and 52 may be formed of a metal having a component different from that of the porous metal layers 41 and 51, but in the case of being formed of Au, the same component, the porous metal layers 41 and 51 are bonded to the metal films 42 and 52 with a stronger bonding force than in the case of being provided on another metal film having a different component. Note that when the porous metal layers 41 and 51 are components other than Au (for example, Cu, silver (Ag) or platinum (Pt)), the same metal (for example, Cu, silver (Ag) or platinum (Pt)) as the porous metal layers 41 and 51 can be used for the metal films 42 and 52.

Next, a process of forming the bumps 4a and a sidewall portion 5a illustrated in FIG. 10 on the chip 3 will be described. As illustrated in FIG. 7, in the case of forming the bumps 4a and the sidewall portion 5 on the chip 3, first, the metal film 32 is formed on the upper surfaces of the connection pads 31 provided at the position where the bumps 4a are to be formed later on the chip 3. At this time, at the same time, the metal film 32 is also formed on the upper surfaces of the connection pads 31 provided at the position where the sidewall portion 5a is to be formed later, that is, the upper surfaces of the connection pads 31 provided at the position annularly surrounding the region where the bumps 4a are to be formed later on the main surface of the chip 3. As a material of the metal film 32, a metal having the same component as that of a metal film 74 (see FIG. 8) to be stacked later is selected. Note that, here, the metal film 32 of Au is formed. Note that the connection pads 31 provided at the position where the sidewall portion 5a is to be formed later are not connected to the circuit inside the chip 3.

Thereafter, a photoresist layer 71 is formed on the surface of the chip 3 on the side where the connection pads 31 and the metal films 32 are provided. Thereafter, through-holes 72 are formed at the position where the bumps 4a are to be formed in the photoresist layer 71 by a photolithography technique to expose the surface of the metal films 32. At the same time, a groove 73 is formed at the position where the sidewall portion 5a is to be formed to expose the surface of the metal film 32.

Thereafter, as illustrated in FIG. 8, the metal film 74 is formed on the upper surface of the photoresist layer 71, the side surfaces of the through-holes 72, the side surfaces of the groove 73, and the upper surfaces of the metal films 32 by, for example, sputtering. As a material of the metal film 74, Au having the same component as the Au particles contained in the paste 50 to be charged into the through-holes 72 later is selected.

Hence, since the photoresist layer 71 is cured by coating the surface with the metal film 43, it is possible to prevent the fine structure from being collapsed when the through-holes 72 are filled with the paste 50 containing Au particles.

In addition, also here, a thin (for example, a thickness of less than 1 µm) metal film 74 is formed such that the proportion of a film thickness d1 of the metal film 74 to a depth D1 of the through-hole 72, in other words, a thickness of the bump 4a to be formed later (a height D1 of the bump 4a) in the direction orthogonal to the main surface of the chip 3 is less than 10%.

For example, in the case of forming the bumps 4 having a height of 10 µm arranged at a 20 µm pitch, the film thickness of the metal film 74 is set to 0.2 µm. Hence, even when the metal film 74 is formed, it is possible to prevent the openings of the through-holes 72 from being narrowed, so that the through-holes 72 can be sufficiently filled with the paste 50 containing metal particles in a later process.

As a result, the proportion of the film thickness d1 of the metal film 74 to a depth D2 of the groove 73, in other words, a thickness of the sidewall portion 5a to be formed later (a height D2 of the sidewall portion 5a) in the direction orthogonal to the main surface of the chip 3 is less than 10%.

Subsequently, as illustrated in FIG. 9, the through-holes 72 and the groove 73 formed in the photoresist layer 71 are filled with the paste 50 containing Au particles having, for example, a purity of 99.9 wt% or more and a particle diameter of 0.005 µm to 1.0 µm.

Thereafter, the paste 50 is dried and sintered, and then the photoresist layer 71 is stripped by lift-off using a stripping solution or the like. Hence, as illustrated in FIG. 10, the metal film 32 of Au, the metal film 42 of Au, and the porous metal layer 41 containing Au particles having a particle diameter of 0.005 µm to 1.0 µm are sequentially stacked on the surface of the connection pads 31, and the bumps 4a in which the metal film 42 of Au is also formed on the side surfaces of the porous metal layers 41 are completed.

At the same time, the metal film 32 of Au, the metal film 52 of Au, and the porous metal layer 51 containing Au particles having a particle diameter of 0.005 µm to 1.0 µm are sequentially stacked to surround the region where the bumps 4a are formed, and the sidewall portion 5a in which the metal film 52 of Au is also formed on the side surfaces of the porous metal layer 51 is completed.

As described above, the bump 4a includes the metal film 42 in which the proportion of the film thickness to the height D1 of the bump 4a is less than 10% between the metal film 22 on the connection pad 31 and the porous metal layer **41.** Further, the bump 4a is also provided with the metal film 42 on the side surface of the porous metal layer **41.**

In addition, the sidewall portion 5a includes the metal film 52 in which the proportion of the film thickness to the height D2 of the sidewall portion 5a is less than 10% between the metal film 32 on the connection pad 31 and the porous metal layer 51. Further, the sidewall portion 5a is also provided with the metal film 52 on the side surfaces of the porous metal layer 51.

The metal films 42 and 52 are formed on the upper surface of the photoresist layer 71, the side surfaces of the through-holes 72 and the groove 73 formed in the photoresist layer 71, and the surface of the metal film 22 in order to prevent collapse of the fine structures of the bumps 4a and the sidewall portion 5a patterned in the photoresist layer 71. Hence, the bumps 4a can have a fine pitch having a pitch of 20 µm or less similarly to the bumps 4 on the semiconductor substrate 2 side.

In the above-described embodiment, the case where the chip 3 not provided with the bumps 4a and the sidewall portion 5a is mounted on the semiconductor substrate 2 provided with the bumps 4 and the sidewall portion **5,** and the case where the chip 3 provided with the bumps 4a and the sidewall portion 5a is mounted on the semiconductor substrate 2 not provided with the bumps 4 and the sidewall portion 5 have been described, but these are examples.

The electronic device according to the present disclosure may have a configuration in which the chip 3 provided with the bumps 4a and the sidewall portion 5a is mounted on the semiconductor substrate 2 provided with the bumps 4 and the sidewall portion 5. In the case of such a configuration, the proportion of the film thickness of the metal films 42 and 52 to half of the thickness of the bumps 4 and 4a and the sidewall portions 5 and 5a in the direction orthogonal to the main surfaces of the semiconductor substrate 2 and the chip 3 is set to less than 10%, preferably less than 5%.

In addition, in the above-described embodiment, the case where the base material of the chip 3 is a base material other than Si has been described, but the base material of the chip 3 may be Si doped with impurities as long as the thermal expansion coefficient is different from that of the semiconductor substrate 2.

The chip 3 including the light emitting portion of the semiconductor laser and the semiconductor substrate 2 including the drive circuit for the semiconductor laser described above are mounted, for example, on a distance measuring apparatus such as a ToF sensor or a structured light. When mounted on a distance measuring apparatus, the light emitting portion of the semiconductor laser functions, for example, as the light source of a ToF sensor or the light source of a structured light.

### [3. Effects]

The electronic device 1 includes the semiconductor substrate 2, the chip 3, the bumps 4, and the sidewall portion 5. The bumps 4 connect the plurality of connection pads 21 and 31 provided on the opposing main surfaces of the semiconductor substrate 2 and the chip 3. The sidewall portion 5 includes the porous metal layer 51 that annularly surrounds the region where the plurality of bumps 4 is provided, and connects the semiconductor substrate 2 and the chip 3. Hence, the electronic device 1 can improve airtightness.

The chip 3 has a thermal expansion coefficient different from that of the semiconductor substrate 2 by 0.1 ppm/°C or more. Hence, even when the chip 3 generates heat and expands with a thermal expansion coefficient different from that of the semiconductor substrate 2, the porous metal layer 51 of the sidewall portion 5 is elastically deformed, and thus the electronic device 1 can suppress the occurrence of a crack in and gaps with respect to the sidewall portion 5. Further, even when the chip 3 or the semiconductor substrate 2 has a variation in thickness or warpage, the sidewall portion 5 is elastically deformed following the shape of the chip 3 or the semiconductor substrate 2, so that airtightness can be improved.

The chip 3 is a semiconductor laser. The semiconductor substrate 2 includes the drive circuit that drives the semiconductor laser. Hence, even when the chip 3 expands with a thermal expansion coefficient different from that of the semiconductor substrate 2 due to heat generation as a result of the light emission of the semiconductor laser, the porous metal layer 51 of the sidewall portion 5 is elastically deformed, and the electronic device 1 can improve airtightness.

The porous metal layer 51 contains metal particles having a particle diameter of 0.005 µm to 1.0 µm. The porous metal layer 51 can be metal-bonded at a temperature lower than the melting point of the bulk-shaped metal due to the size effect of the metal particles. Hence, in the electronic device 1, the semiconductor substrate 2 and the chip 3 are connected by the porous metal layer 51 that can be metal-bonded at a relatively low temperature at the peripheral edge portion of the region where the connection pads 21 and 31 and the bumps 4 are provided, and thus it is possible to improve airtightness because damage due to heat is reduced.

The sidewall portion 5 includes the metal film 52 provided at least one of between the porous metal layer 51 and the connection pad 21 provided on the semiconductor substrate 2 and between the porous metal layer 51 and the connection pad 31 provided on the chip **3,** and on the side surfaces of the porous metal layer 51. Hence, the electronic device 1 can improve airtightness by preventing collapse of the porous metal layer 51 by the metal film 52 provided on the side surfaces of the porous metal layer 51.

The metal film 52 provided at least one of between the porous metal layer 51 and the connection pad 21 provided on the semiconductor substrate 2 and between the porous metal layer 51 and the connection pad 31 provided on the chip 3 has a proportion of the film thickness to the thickness of the sidewall portions 5 and 5a in the direction orthogonal to the main surfaces of less than 10%. Hence, it is possible to prevent the grooves 63 and 73 for forming the sidewall portions 5 and 5a patterned in the photoresist layers 61 and 71 from being narrowed by the formation of the metal film **52.** As a result, the grooves 63 and 73 patterned in the photoresist layers 61 and 71 can be appropriately filled with the paste 50 containing metal particles to be the material of the sidewall portions 5 and **5a.**

The metal film 52 provided at least one of between the porous metal layer 51 and the connection pad 21 provided on the semiconductor substrate 2 and between the porous metal layer 51 and the connection pad 31 provided on the chip 3 has a proportion of the film thickness to half of the thickness of the sidewall portions 5 and 5a in the direction orthogonal to the main surfaces of less than 10%. Hence, in the case of the electronic device in which the semiconductor substrate 2 and the chip 3 are connected by the sidewall portions 5 and **5a, it** is possible to prevent the grooves 63 and 73 for forming the sidewall portions 5 and 5a patterned in the photoresist layers 71 and 71 from being narrowed by the formation of the metal film **52.** As a result, the grooves 63 and 73 patterned in the photoresist layers 61 and 71 can be appropriately filled with the paste 50 containing metal particles to be the material of the sidewall portions 5 and 5a.

The bumps 4 and 4a have the porous metal layer 41 and the metal film 42. The porous metal layer 41 is formed of the same material as the porous metal layer 51 of the sidewall portions 5 and 5a. The metal film 42 is provided at least one of between the porous metal layer 41 and the connection pad 21 provided on the semiconductor substrate 2 and between the porous metal layer 41 and the connection pad 31 provided on the chip 3, and on the side surface of the porous metal layer 41. Hence, since the bumps 4 and 4a and the sidewall portions 5 and 5a can be formed simultaneously, the semiconductor substrate 2 and the chip 3 can be bonded and sealed by forming the sidewall portions 5 and 5a without adding a new process for bonding and sealing.

In the metal film 42 provided between the porous metal layer 41 and the connection pads 21 and 31, the proportion of the film thickness to the thickness of the bumps 4 and 4a in the direction orthogonal to the main surface of the semiconductor substrate 2 is less than 10%. Hence, the through-holes 62 and 72 for forming the bumps 4 and 4a patterned in the photoresist layers 61 and 71 can be prevented from being narrowed by the formation of the metal film 42. As a result, the through-holes 62 and 72 patterned in the photoresist layers 61 and 71 can be appropriately filled with the paste 50 containing metal particles to be the material of the bumps 4 and 4a.

In the metal film 42 provided between the porous metal layer 41 and the connection pads 21 and 31, the proportion of the film thickness to half of the thickness of the bumps 4 and 4a in the direction orthogonal to the main surface of the semiconductor substrate 2 is less than 10%. Hence, in the case of the electronic device in which the semiconductor substrate 2 and the chip 3 are connected by the bumps 4 and 4a, it is possible to prevent the through-holes 62 and 72 for forming the bumps 4 and 4a patterned in the photoresist layers 61 and 71 from being narrowed by the formation of the metal film 42. As a result, the through-holes 62 and 72 patterned in the photoresist layers 61 and 71 can be appropriately filled with the paste 50 containing metal particles to be the material of the bumps 4 and 4a.

The materials of the porous metal layers 41 and 51 and the metal films 42 and 43 are the same kind of metal. Hence, the bonding strength between the porous metal layers 41 and 51 and the metal films 42 and 43 can be increased.

The material of the porous metal layers 41 and 51 is a porous metal including gold, silver, platinum, or copper having a purity of 99.9 wt% or more. Hence, the connection resistance between the connection pads 21 of the semiconductor substrate 2 and the connection pads 31 of the chip 3 can be suppressed to be low.

Note that the effects described in the present specification are merely examples and are not limitative, and there may be other effects.

### Reference Signs List

1 ELECTRONIC DEVICE
2 SEMICONDUCTOR SUBSTRATE
3 CHIP
4, 4a BUMP
5, 5a SIDEWALL PORTION
50 PASTE
21, 31 CONNECTION PAD
41, 51 POROUS METAL LAYER
22, 32, 42, 52, 64, 74 METAL FILM
61, 71 PHOTORESIST LAYER
62, 72 THROUGH-HOLE
63, 73 GROOVE

## Claims

1. An electronic device (1) comprising:
a semiconductor substrate (2);
a chip (3);
a bump (4, 4a) that connects a plurality of connection pads (21, 31) provided on opposing main surfaces of the semiconductor substrate (2) and the chip (3); and
a sidewall portion (5, 5a) that includes a porous metal layer (51) annularly surrounding a region where a plurality of the bumps (4, 4a) is provided, and connects the semiconductor substrate (2) and the chip (3).

2. The electronic device (1) according to claim 1, wherein
the chip (3) has a thermal expansion coefficient different from a thermal expansion coefficient of the semiconductor substrate by 0.1 ppm/°C or more.

3. The electronic device (1) according to claim 1, wherein
the chip (3) is a semiconductor laser, and
the semiconductor substrate (2) includes a drive circuit that drives the semiconductor laser.

4. The electronic device (1) according to claim 1, wherein
the porous metal layer (51) contains metal particles having a particle diameter of 0.005 µm to 1.0 µm.

5. The electronic device (1) according to claim 1, wherein
the sidewall portion (5, 5a) includes a metal film (22, 32) provided at least one of between the porous metal layer (51) and the connection pad (21) provided on the semiconductor substrate (2) and between the porous metal layer (51) and the connection pad (31) provided on the chip (3), and on a side surface of the porous metal layer (51).

6. The electronic device (1) according to claim **5,** wherein
the metal film **(22,** 32) provided at least one of between the porous metal layer (51) and the connection pad (21) provided on the semiconductor substrate (2) and between the porous metal layer (51) and the connection pad (31) provided on the chip (3) has a proportion of a film thickness to a thickness of the sidewall portion **(5,** 5a) in a direction orthogonal to the main surface of less than 10%.

7. The electronic device (1) according to claim **5,** wherein
the metal film **(22,** 32) provided at least one of between the porous metal layer (51) and the connection pad (21) provided on the semiconductor substrate (2) and between the porous metal layer (51) and the connection pad (31) provided on the chip (3) has a proportion of a film thickness to half of a thickness of the sidewall portion **(5,** 5a) in a direction orthogonal to the main surface of less than 10%.

8. The electronic device (1) according to claim **1,** wherein
the bump **(4,** 4a) includes
a porous metal layer (41) formed of a same material as the porous metal layer (51) of the sidewall portion (5, **5a),** and
a metal film (42) provided at least one of between the porous metal layer (41) and the connection pad (21) provided on the semiconductor substrate (2) and between the porous metal layer (41) and the connection pad (32) provided on the chip **(3),** and on a side surface of the porous metal layer (41).

9. The electronic device (1) according to claim **8,** wherein
in the metal film (42) provided between the porous metal layer (41) and the connection pad **(21,** 31), a proportion of a film thickness to a thickness of the bump in a direction orthogonal to the main surface is less than 10%.

10. The electronic device according to claim 8, wherein
in the metal film (42) provided between the porous metal layer (41) and the connection pad (21, 31), a proportion of a film thickness to half of a thickness of the bump in a direction orthogonal to the main surface is less than 10%.

11. The electronic device according to claim 5, wherein
materials of the porous metal layer (41, 51) and the metal film (22, 32, 42) are the same metal.

12. The electronic device according to claim 1, wherein
a material of the porous metal layer (51) is a porous metal including gold, silver, platinum, or copper having a purity of 99.9 wt% or more.

## Patentansprüche

1. Elektronische Vorrichtung (1), umfassend:
ein Halbleitersubstrat (2);
einen Chip (3);
einen Höcker (4, 4a), der eine Vielzahl von auf gegenüberliegenden Hauptflächen des Halbleitersubstrats (2) und des Chips (3) bereitgestellten Verbindungspads (21, 31) verbindet; und
einen Seitenwandabschnitt (5, 5a), der eine poröse Metallschicht (51), die einen Bereich, in dem eine Vielzahl der Höcker (4, 4a) bereitgestellt ist, ringförmig umgibt, einschließt und das Halbleitersubstrat (2) und den Chip (3) verbindet.

2. Elektronische Vorrichtung (1) nach Anspruch 1, wobei
der Chip (3) einen Koeffizienten der thermischen Ausdehnung aufweist, der sich um 0,1 ppm/°C oder mehr von einem Koeffizienten der thermischen Ausdehnung des Halbleitersubstrats unterscheidet.

3. Elektronische Vorrichtung (1) nach Anspruch 1, wobei
der Chip (3) ein Halbleiterlaser ist und
das Halbleitersubstrat (2) eine Antriebsschaltung, die den Halbleiterlaser antreibt, einschließt.

4. Elektronische Vorrichtung (1) nach Anspruch 1, wobei
die poröse Metallschicht (51) Metallpartikel mit einem Partikeldurchmesser von 0,005 µm bis 1,0 µm enthält.

5. Elektronische Vorrichtung (1) nach Anspruch 1, wobei
der Seitenwandabschnitt (5, 5a) einen Metallfilm (22, 32), der an mindestens einem von zwischen der porösen Metallschicht (51) und dem auf dem Halbleitersubstrat (2) bereitgestellten Verbindungspad (21) und zwischen der porösen Metallschicht (51) und dem auf dem Chip (3) bereitgestellten Verbindungspad (31) und auf einer Seitenoberfläche der porösen Metallschicht (51) bereitgestellt ist, einschließt.

6. Elektronische Vorrichtung (1) nach Anspruch 5, wobei
der Metallfilm (22, 32), der an mindestens einem von zwischen der porösen Metallschicht (51) und dem auf dem Halbleitersubstrat (2) bereitgestellten Verbindungspad (21) und zwischen der porösen Metallschicht (51) und dem auf dem Chip (3) bereitgestellten Verbindungspad (31) bereitgestellt ist, ein Verhältnis einer Filmdicke zu einer Dicke des Seitenwandabschnitts (5, 5a) in einer Richtung orthogonal zur Hauptoberfläche von weniger als 10 % aufweist.

7. Elektronische Vorrichtung (1) nach Anspruch 5, wobei
der Metallfilm (22, 32), der an mindestens einem von zwischen der porösen Metallschicht (51) und dem auf dem Halbleitersubstrat (2) bereitgestellten Verbindungspad (21) oder zwischen der porösen Metallschicht (51) und dem auf dem Chip (3) bereitgestellten Verbindungspad (31) bereitgestellt ist, ein Verhältnis einer Filmdicke zur Hälfte einer Dicke des Seitenwandabschnitts (5, 5a) in einer Richtung orthogonal zur Hauptoberfläche von weniger als 10 % aufweist.

8. Elektronische Vorrichtung (1) nach Anspruch 1, wobei
der Höcker (4, 4a) einschließt
eine poröse Metallschicht (41), die aus einem gleichen Material wie die poröse Metallschicht (51) des Seitenwandabschnitts (5, 5a) gebildet ist, und
einen Metallfilm (42), der an mindestens einem von zwischen der porösen Metallschicht (41) und dem auf dem Halbleitersubstrat (2) bereitgestellten Verbindungspad (21) und zwischen der porösen Metallschicht (41) und dem auf dem Chip (3) bereitgestellten Verbindungspad (32) und auf einer Seitenoberfläche der porösen Metallschicht (41) bereitgestellt ist.

9. Elektronische Vorrichtung (1) nach Anspruch 8, wobei
in dem zwischen der porösen Metallschicht (41) und dem Verbindungspad (21, 31) bereitgestellten Metallfilm (42) ein Verhältnis einer Filmdicke zu einer Dicke des Höckers in einer Richtung orthogonal zur Hauptoberfläche kleiner als 10 % ist.

10. Elektronische Vorrichtung nach Anspruch 8, wobei
in dem zwischen der porösen Metallschicht (41) und dem Verbindungspad (21, 31) bereitgestellten Metallfilm (42) ein Verhältnis einer Filmdicke zur Hälfte einer Dicke des Höckers in einer Richtung orthogonal zur Hauptoberfläche kleiner als 10 % ist.

11. Elektronische Vorrichtung nach Anspruch 5, wobei
Materialien der porösen Metallschicht (41, 51) und des Metallfilms (22, 32, 42) das gleiche Metall sind.

12. Elektronische Vorrichtung nach Anspruch 1, wobei
ein Material der porösen Metallschicht (51) ein poröses Metall ist, das Gold, Silber, Platin oder Kupfer mit einer Reinheit von 99,9 Gew.-% oder mehr einschließt.

## Revendications

1. Dispositif électronique (1) comprenant :
un substrat semi-conducteur (2) ;
une puce (3) ;
un bossage (4, 4a) qui connecte une pluralité de plots de connexion (21, 31) fournis sur des surfaces principales opposées du substrat semi-conducteur (2) et de la puce (3) ; et
une partie de paroi latérale (5, 5a) qui comporte une couche métallique poreuse (51) entourant de façon annulaire une région où une pluralité des bossages (4, 4a) est fournie, et connecte le substrat semi-conducteur (2) et la puce (3).

2. Dispositif électronique (1) selon la revendication 1, dans lequel
la puce (3) a un coefficient de dilatation thermique différent d'un coefficient de dilatation thermique du substrat semi-conducteur de 0,1 ppm/°C ou plus.

3. Dispositif électronique (1) selon la revendication 1, dans lequel
la puce (3) est un laser à semi-conducteur, et
le substrat semi-conducteur (2) comporte un circuit de pilotage qui pilote le laser à semi-conducteur.

4. Dispositif électronique (1) selon la revendication 1, dans lequel
la couche métallique poreuse (51) contient des particules métalliques ayant un diamètre particulaire de 0,005 µm à 1,0 µm.

5. Dispositif électronique (1) selon la revendication 1, dans lequel
la partie de paroi latérale (5, 5a) comporte un film métallique (22, 32) fourni au niveau d'au moins l'un parmi entre la couche métallique poreuse (51) et le plot de connexion (21) fourni sur le substrat semi-conducteur (2) et entre la couche métallique poreuse (51) et le plot de connexion (31) fourni sur la puce (3), et sur une surface latérale de la couche métallique poreuse (51).

6. Dispositif électronique (1) selon la revendication 5, dans lequel
le film métallique (22, 32) fourni au niveau d'au moins l'un parmi entre la couche métallique poreuse (51) et le plot de connexion (21) fourni sur le substrat semi-conducteur (2) et entre la couche métallique poreuse (51) et le plot de connexion (31) fourni sur la puce (3) a une proportion d'une épaisseur de film à une épaisseur de la partie de paroi latérale (5, 5a) dans une direction orthogonale à la surface principale inférieure à 10 %.

7. Dispositif électronique (1) selon la revendication 5, dans lequel
le film métallique (22, 32) fourni au niveau d'au moins l'un parmi entre la couche métallique poreuse (51) et le plot de connexion (21) fourni sur le substrat semi-conducteur (2) et entre la couche métallique poreuse (51) et le plot de connexion (31) fourni sur la puce (3) a une proportion d'une épaisseur de film à la moitié d'une épaisseur de la partie de paroi latérale (5, 5a) dans une direction orthogonale à la surface principale inférieure à 10 %.

8. Dispositif électronique (1) selon la revendication 1, dans lequel
le bossage (4, 4a) comporte
une couche métallique poreuse (41) formée d'un même matériau que la couche métallique poreuse (51) de la partie de paroi latérale (5, 5a), et
un film métallique (42) fourni au niveau d'au moins l'un parmi entre la couche métallique poreuse (41) et le plot de connexion (21) fourni sur le substrat semi-conducteur (2) et entre la couche métallique poreuse (41) et le plot de connexion (32) fourni sur la puce (3), et sur une surface latérale de la couche métallique poreuse (41).

9. Dispositif électronique (1) selon la revendication 8, dans lequel
dans le film métallique (42) fourni entre la couche métallique poreuse (41) et le plot de connexion (21, 31), une proportion d'une épaisseur de film à une épaisseur du bossage dans une direction orthogonale à la surface principale est inférieure à 10 %.

10. Dispositif électronique selon la revendication 8, dans lequel
dans le film métallique (42) fourni entre la couche métallique poreuse (41) et le plot de connexion (21, 31), une proportion d'une épaisseur de film à la moitié d'une épaisseur du bossage dans une direction orthogonale à la surface principale est inférieure à 10 %.

11. Dispositif électronique selon la revendication 5, dans lequel
les matériaux de la couche métallique poreuse (41, 51) et du film métallique (22, 32, 42) sont le même métal.

12. Dispositif électronique selon la revendication 1, dans lequel
un matériau de la couche métallique poreuse (51) est un métal poreux comportant or, argent, platine ou cuivre ayant une pureté de 99,9 % en poids ou plus.
